(19) **Europäisches Patentamt**

**European Patent Office**

**Office européen des brevets**

(11) **EP 1 408 512 B1**

(12) **EUROPEAN PATENT SPECIFICATION**

(45) Date of publication and mention
of the grant of the patent:
**28.12.2005 Bulletin 2005/52**

(51) Int Cl.$^7$: **G11C 29/00**

(21) Application number: **02022312.9**

(22) Date of filing: **07.10.2002**

(54) **Method for storing errors of a memory device in a diagnose array having a minimum storing size**

Verfahren zum Speichern von Fehlern einer Speichervorrichtung in einem Diagnosefeld mit minimaler Speicherkapazität

Procédé pour l'emmagasinage d'erreurs d'un dispositif mémoire dans un réseau diagnostique ayant une capacité minimum de stockage

(84) Designated Contracting States:
**DE FR GB IT**

(43) Date of publication of application:
**14.04.2004 Bulletin 2004/16**

(73) Proprietor: **Infineon Technologies AG**
**81669 München (DE)**

(72) Inventors:
• **Collura, Michel**
**83300 Draguignan (FR)**
• **Coste, Jean-Patrice**
**06250 Mougins le haut (FR)**

• **Jallamion, Yannis**
**06250 Mougins (FR)**

(74) Representative:
**Reinhard - Skuhra - Weise & Partner**
**Friedrichstrasse 31**
**80801 München (DE)**

(56) References cited:
**US-A- 5 123 016**     **US-A- 5 910 921**
**US-B1- 6 185 709**     **US-B1- 6 295 237**
**US-B1- 6 310 807**

**Description**

Semiconductor memories are binary data memories in which a plurality of memory cells are provided. The memory cells are addressable by means of wordlines and bitlines. The main memory comprises a matrix of many memory cells connected to address decoding means and sense amplifiers. Addressing a memory cell, i.e. the selection of a memory cell, is performed by activating wordlines which are connected to address decoding means. The data stored in the addressed memory cells are read out by input/output units having sense amplifiers for amplifying the read-out data signal. The input/output units are connected to a data bus by means of which data can be read out from the memory or written into the memory.

US 6,295,237 describes a semiconductor memory configuration, in particular a DRAM, in which redundant memory cells, bitlines and wordlines are determined for failed memory cells, failed word lines and failed bitlines by a built in self test computing unit.

US 5,910,921 describes a DRAM self test circuitry wherein regular word lines and I/O units are replaced by redundant word lines and I/O units using fuses.

When a random access memory is produced, it can happen that some of the memory cells within the matrix are faulty. Accordingly, the produced memory chip is tested, and it is decided whether it can be repaired. For this purpose, there is normally provided an on-chip circuitry to provide testing of the memory chip. The built-in self-test (BIST) is essentially the implementation of logic built into the memory chip to do testing without the use of a tester for data pattern generation on comparison purposes.

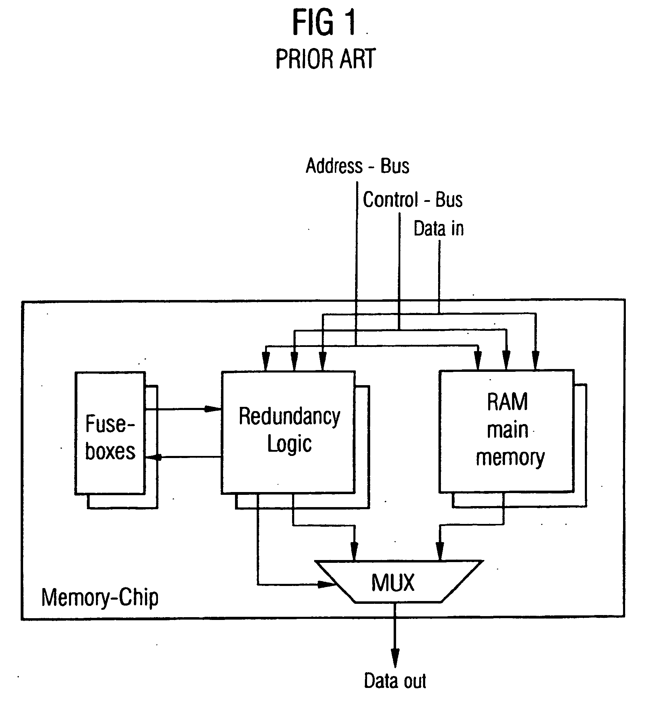

Fig. 1 shows the architecture of a memory chip according to the state of the art. The memory chip comprises a main memory with a plurality of memory cells and a redundancy logic having a built-in self-test device. The memory chip is connected to an address bus, a control bus and a data bus. In a test mode, the addresses of the faulty memory cells are detected. The redundancy logic replaces the faulty memory cells within the main memory with memory cells in the form of redundant registers within the redundancy logic. For this purpose the redundancy logic programs fuses within a fusebox. The address applied to the address bus is compared with the addresses of the detected faulty memory cells, and when there is a match, the redundancy logic maps the faulty address to an address of a register cell within the redundancy logic to replace the faulty memory cell. When reading data from the memory chip, the redundancy logic controls a multiplexer connected to the data bus. When accessing data with an address of a faulty memory cell, the data is read from the register replacing the memory cell within the redundancy logic.

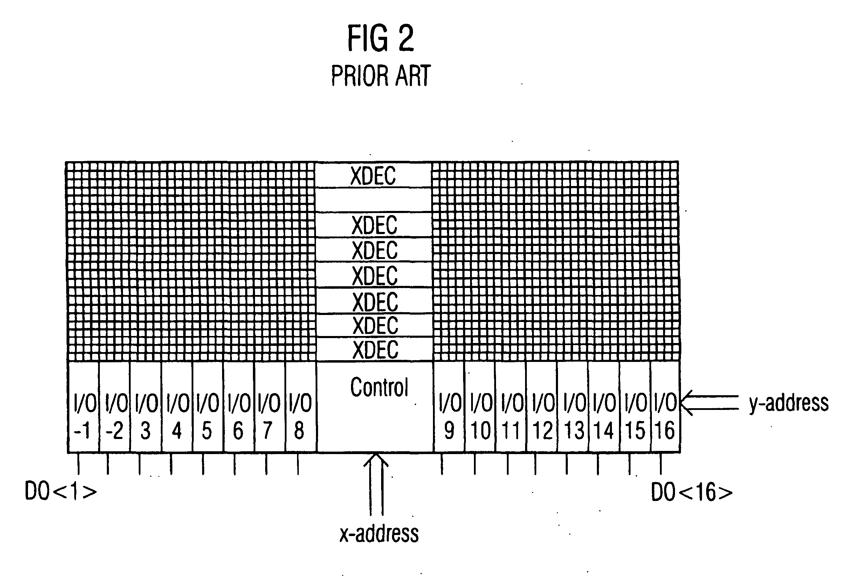

Fig. 2 shows the architecture of a main memory within the memory chip according to the state of the art. In this example, the main memory is a 8k x 16 wide memory having 16 input/output units and wordline address decoders (XDEC) for decoding the wordline address or X-address of the memory cells. The input/output units are connected to the memory cell matrix by means of vertical bitlines. The input/output units receive the bitline address or Y-address of the solected memory cell.

The main memory shown in Fig. 2 according to the state of the art is partitioned in two memory hales wherein the X-address decoders are placed in the center. With this architecture, the length of the wordlines is comparatively short so that the parasitic capacitance of the wordlines can be minimized. Each input/output unit is connected to the 16 bitlines reading data from the addressed memory cell and for writing data into an addressed memory cell.

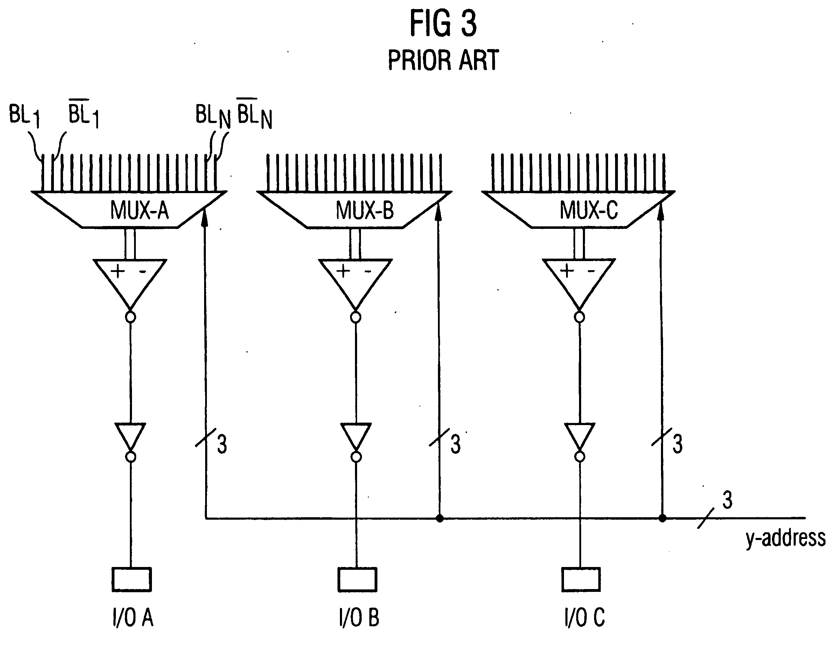

Fig. 3 shows the architecture of an input/output unit according to the state of the art. For reading out data, the input/output unit comprises multiplexers which are connected to the bitlines of the memory cell matrix. In the shown example, each memory cell is connected to a multiplexer via a couple or pair of bitlines BL, $\overline{BL}$ to provide a differential signal to the input of the multiplexer. In the shown example, each multiplexer has N signal inputs. On the output side, each multiplexer is connected to a differential amplifier and an inverter for amplifying the read-out data signal and to supply the data to a data bus. The multiplexers are controlled by the applied Y-address.

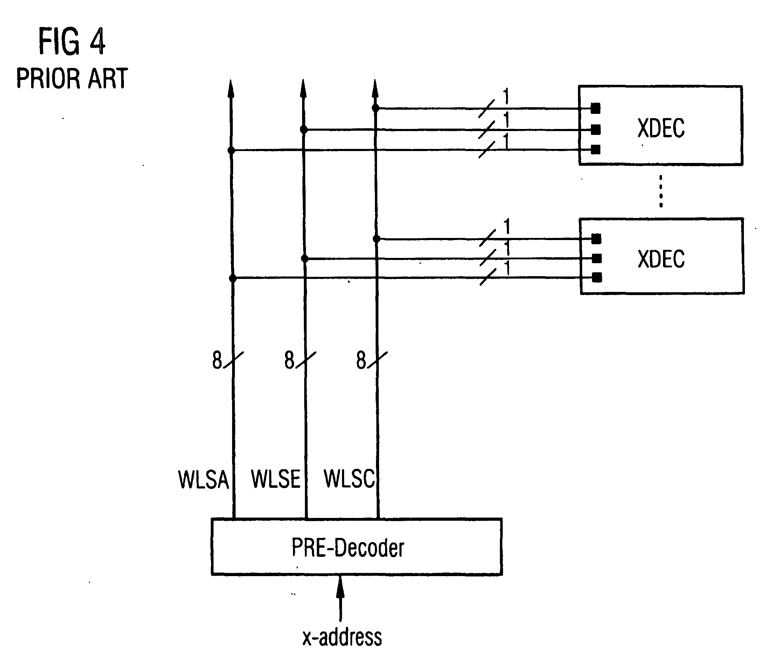

Fig. 4 shows the architecture of an X-address decoder according to the state of the art used in a conventional main memory as shown in Fig. 2. A predecoder is connected via three 8 bit wide busses to X-address decoders which decode the X-address of the selected memory cell within the memory cell matrix.

In a conventional memory, there are provided either redundant registers, redundant bitlines and/or wordlines to repair a memory chip in case that faulty memory cells are detected when testing the memory chip.

If the conventional memory chip comprises redundant registers, the number of faulty addresses is limited by the number of redundant registers provided within the redundancy logic. If there are, for instance, 10 redundant registers, it is only possible to repair 10 faulty addresses. When an address is "faulty", the address is stored in a redundant register. Since the number of faulty addresses detected by the main memory, it is not known before testing a considerable number of registers have to be provided within the redundancy logic to guarantee the repair of the chip even when a lot of memory cells are detected to be faulty.

In case that the memory chip comprises redundant bitlines and/or wordlines, the repair method is much more complex, because all errors have to be known in advance before the error pattern can be diagnosed and an optimal repair solution can be calculated. Storing detected memories with a conventional method implies a very large array.

Such an array needs a lot of space on the memory chip, thus increasing costs when producing the memory chip.

Accordingly, it is the object of the present invention to provide a method for storing detected errors in a separate diagnose array having a minimum storage and to provide a memory chip having a diagnose array with a minimum storage size for storing detected errors of a main memory within the memory chip.

This object is solved by a method having the features of main claim 1 and by a memory chip having the features of main claim 6.

The invention provides a method for storing detected errors of a main memory in a separate diagnose array within the diagnose unit having a minimum storage size,

wherein the faulty main memory to be repaired comprises a plurality of memory cells which are addressable by means of wordlines connected to wordline address decoders and by means of bitlines connected to input/output units, wherein said method comprising the following steps:

(a) providing a faulty diagnose array having several lines, wherein the number of lines is equal to the number of independent errors of the faulty main memory that can be repaired, wherein in each line of said diagnose array are storable:

(a1) at least one wordline number of a wordline of a detected faulty memory cell,
(a2) an input/output unit number of an input/output unit of the detected faulty memory cell,
(a3) at least one first flag which indicates whether a new error on the same wordline, but with a different input/output unit has occurred, and
(a4) a second flag which indicates whether a further faulty wordline with the same input/output unit has occurred;

(b) comparing the wordline number and the input/output number of the detected faulty memory cell with the data content of the fault diagnose array,

(b1) if the wordline number and the input/output unit number of the detected faulty memory cell are already stored in a line of said array, then no update of said fault diagnose array is performed,
(b2) else, if the input/output unit number of the detected faulty memory cell is already stored in a line of said fault diagnose array, the wordline number is stored in said line,
(b3) else, if the wordline number of the detected faulty memory cell is already stored in a line of said array, a first flag is set in said line,
(b4) else, if a further line is available in said fault diagnose array, the wordline number and input/output unit number of the detected faulty memory cell is written into said further line,
(b5) else, it is indicated that the main memory cannot be repaired.

In a preferred embodiment, the detected errors stored in said diagnose array are analyzed to select wordlines and input/output units to be replaced by redundant wordlines and redundant input/output units of said main memory.

Analyzing the errors is performed in a preferred embodiment by a control unit within said diagnose unit connected to said diagnose array.

In a preferred embodiment, analyzing the errors comprises the following steps for each line of said diagnose array, if the first flag is set within the line, it is decided that the corresponding wordline is to be replaced by a redundant wordline;

if the second flag is set within the line, it is decided that the faulty input/output unit is to be replaced by a redundant input/output unit;

if the second flag is not set and the first flag is not set, it is decided that either the faulty input/output unit is replaced by a redundant input/output unit or the faulty wordline by a redundant wordline.

In a further preferred embodiment, the diagnose unit controls a repair unit to program fuses for replacing wordlines by redundant wordlines and input/output units by redundant input/output units according to the analyzing result.

The invention further provides a memory chip comprising a main memory with a plurality of memory cells which are addressable by means of wordlines connected to wordline address decoders and by means of bitlines connected to input/output units,

wherein the main memory has redundant wordlines connected to redundant wordline address decoders and redundant bitlines connected to redundant input/output units;

a built-in self-test unit for detecting faulty memory cells in said main memory,

a diagnose unit having a diagnose array for storing logically detected errors of the main memory.

In the memory chip according to present invention, in each line of the diagnose array are storable
at least one wordline number of a wordline connected to a detected faulty memory cell,
an input/output unit number of an input/output unit connected to the detected faulty memory cell,
at least one first flag which indicates whether a new error on the same wordline, but with a different input/output unit has occurred, and
a second flag which indicates whether a further faulty wordline with the same input/output unit has occurred.

In the memory chip according to the present invention, the diagnose unit analyzes the detected errors stored in said diagnose array to select wordlines in the input/output units to be replaced by redundant wordlines and redundant input/output units of said main memory.

In a further preferred embodiment of the memory chip according the present invention, the diagnose unit controls a repair unit to program fuses for replacing wordlines by redundant wordlines and input/output units by redundant input/output units according to the analyzing result.

A preferred embodiment of the method according to the present invention and of the memory chip according to the present invention is explained with reference to the enclosed figures:

Fig. 1 shows a memory chip with a redundancy logic according to the state of the art;

Fig. 2 shows the main memory within a memory chip according to the state of the art;

Fig. 3 shows an input/output unit according to the state of the art;

Fig. 4 shows an X-address decoder according to the state of the art;

Fig. 5 shows the architecture of a memory chip according to the present invention;

Fig. 6 shows a diagnose unit within a memory chip according to the present invention;

Fig. 7 shows a main memory within a memory chip with a redundancy according to the present invention;

Fig. 8 shows an X-address decoder within a memory chip according to the present invention;

Fig. 9 shows an input/output unit within a memory chip according to the present invention;

Fig. 10 shows a preferred embodiment of a diagnose array according to the present invention;

Fig. 11 shows the process of storing detected errors of the main memory in the diagnose array according to the present invention.

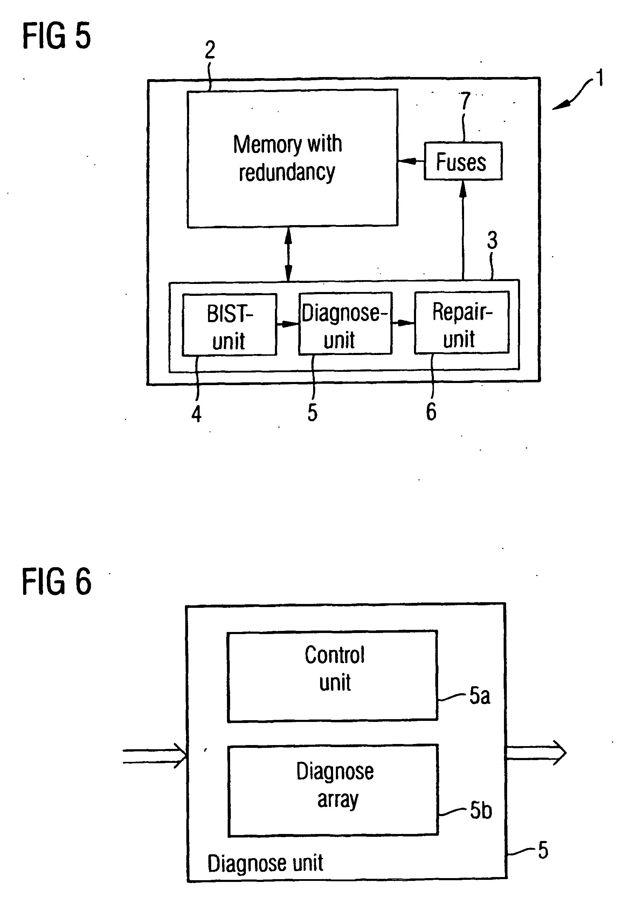

As can be seen from Fig. 5, the memory chip 1 according to the present invention comprises a memory 2 with a built-in redundancy. The memory 2 comprises a plurality of memory cells which are addressable by means of wordlines and bitlines. The memory comprises redundant wordlines and redundant bitlines which are provided for repairing faulty memory cells. The memory 2 is connected to a control block 3, a BIST-unit 4 and a repair unit 6. The repair unit 6 is connected to programmable fuses 7 which are provided for replacing wordlines by redundant wordlines and input/output units by redundant input/output units within the memory 2.

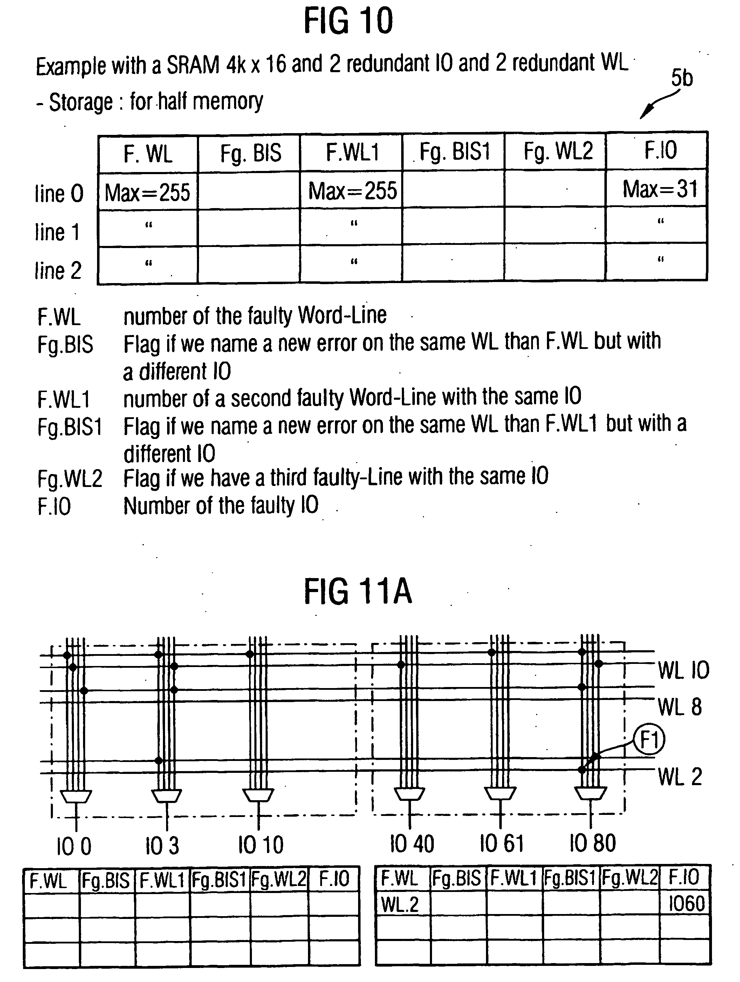

The built-in self-test unit 4 performs a test of the memory 2 within the chip 1 and checks whether there are any memory cells which are defect. The diagnose unit 5 consists of a control unit 5a and a diagnose array 5b as shown in Fig. 6. The diagnose array 5b is provided for storing logically detected errors within the main memory 2 found by the built-in self-test device 4 in a test mode. The control unit 5a controls the method according to the present invention for storing detected errors of the main memory 2 in the separate diagnose array 5b within the diagnose unit 5. Fig. 10 shows an example of a table stored within the diagnose array 5b. The method according to the present invention allows to minimize the storage capacity or storage size of the diagnose array 5b. The diagnose array 5b stores in a logical manner the errors found in the memory 2. The control unit 5a controls the storing of detected errors into the diagnose array 5b and analyzes the stored errors to select wordlines and input/output units within the memory 2 to be replaced by redundant wordlines and redundant input/output units. Depending on the analyzing result, the repair unit programs fuses in a fusebox connected to the main memory 2. A basis of the data content of the storage table within the diagnose array 5b, the repair unit 6 performs a pre-fuse of the fuses to replace wordlines in the input/output unit of faulty memory cells by redundant wordlines and redundant input/output units. In the next step, the provisionally repaired memory 2 is again tested, and if no further errors are detected, the fuses in the fusebox 7 are blown.

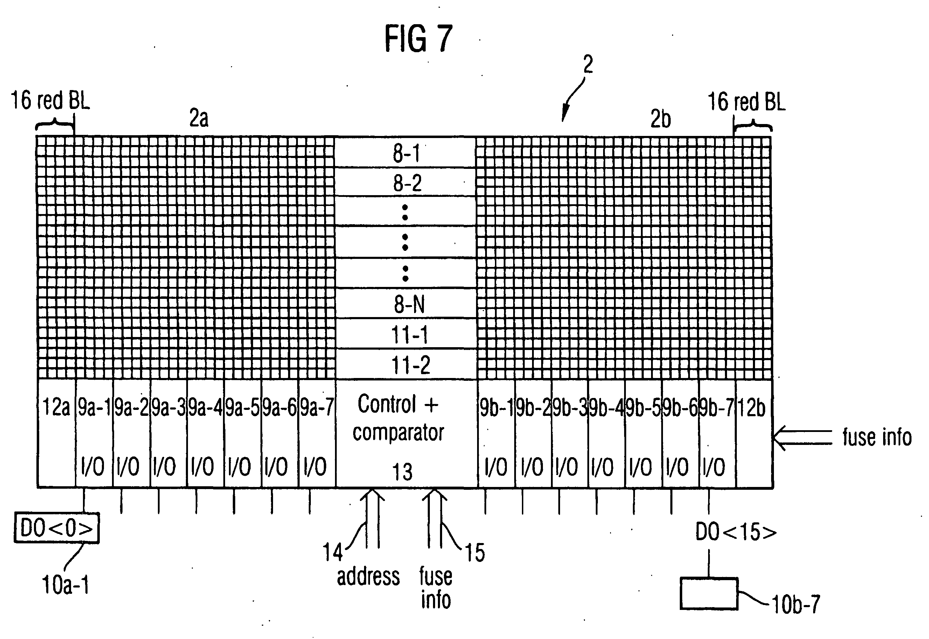

Fig. 7 shows a memory 2 within a memory chip 1 as shown in Fig. 5. In the embodiment shown in Fig. 7, the memory is partitioned in two memory hales 2a, 2b, each having a matrix of memory cells. The memory cells are connected to x-address-decoders 8 and to input/output units 9. The input/output units 9 are connected to data input/output pads 10 of the memory chip 1. In the given example, each input/output unit 9 is connected to 16 bitlines.

As can be seen from Fig. 7, the memory 2 further comprises redundant X-address decoders 11 and redundant input/output units 12a, 12b. Further, a control and comparator unit 13 is provided connected to the address bus 14 and to the fusebox 7 via lines 15.

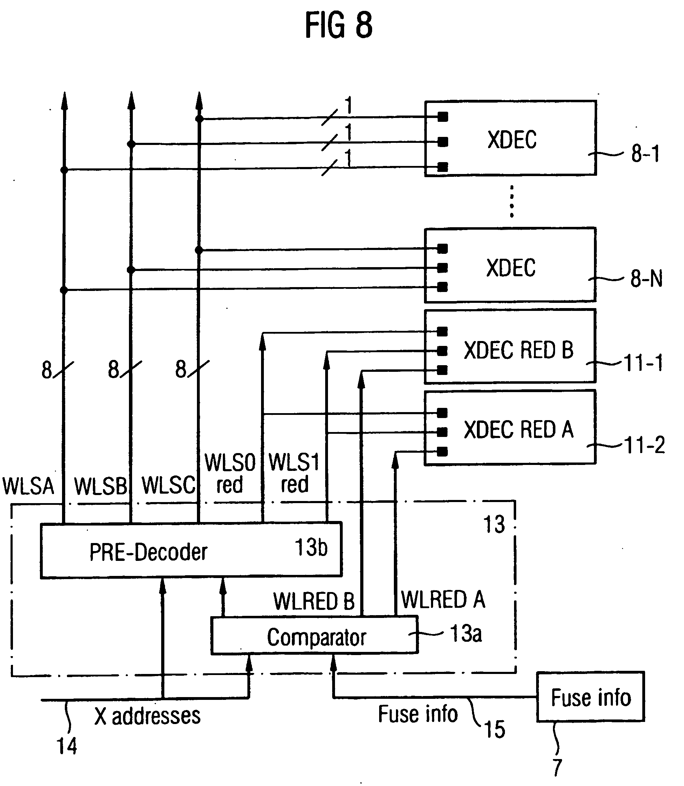

Fig. 8 shows a preferred embodiment of the address decoding unit within memory 2, as shown in Fig. 7. The applied X-addresses are compared by a comparator unit 13a with a fuse info from the fusebox 7. Depending on the programmed fuses, the X-address decoders 8-1 to 8-n may be replaced by redundant X-address decoders 11-1, 11-2.

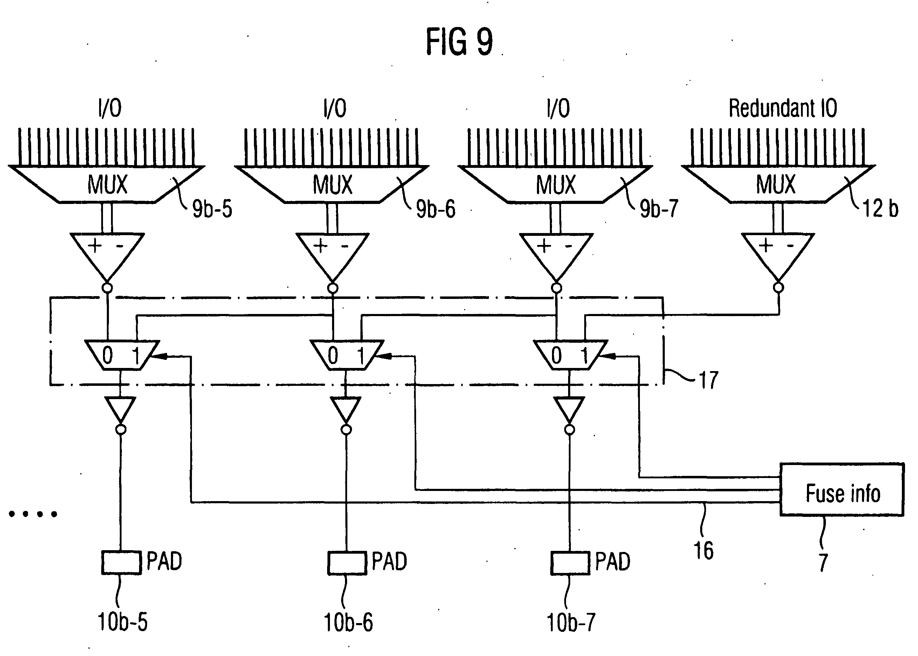

Fig. 9 shows the architecture of the input/output units 9 in the memory chip 1 according to the present invention. As can be seen from Fig. 9, there is provided a redundant input/output unit 12b which may be activated by the programmed fuses 7. The fusebox 7 is connected via control lines 16 to multiplexers within the multiplex stage 17. The fusebox 7 comprises the information data on the input/output unit 9 to be replaced by the redundant input/output unit 12. A control signal is supplied to the multiplexer stage 17 to block the input/output 9 which is connected to a faulty memory cell within the memory 2 and which is decided to be replaced from the corresponding pad 10. Further, the redundant input/output unit 12b is connected to pad 10b-7 as a substitute. The redundant input/output unit 12b is set by the fuses. Providing the additional multiplexer stage 17 has almost no impact on the signal delay.

Fig. 10 shows a preferred embodiment of a diagnose array within a diagnose unit 5. In the diagnose array 5b, a fault diagnose table is stored for each half 2a, 2b of the memory 2. The fault diagnose array 5b has several lines, wherein the number of lines is equal to the number of independent errors which can be repaired in the faulty main memory 2.

In the given example shown in Fig. 10, three lines, line 0, line 1, line 2, are provided. The diagnose array 5b shown in Fig. 10 comprises several columns. The first column F.WL indicates the number of a faulty wordline detected in the memory 2. The next column Fg.BIS is a flag which is set when there is a new error on the same wordline as in F.WL, but with a different input/output unit. In the next column F.WL1, the wordline number of a second faulty wordline with the same input/output unit can be stored. Fg.BIS1 is a flag which indicates when set that there is a new error on the same wordline as F.WL1, but with a different input/output unit. Fg.WL2 is a flag which is set when there is a third faulty wordline with the same input/output unit. In the last column F.IO, the input/output unit number of the faulty input/output unit 9 of the memory 2 can be stored.

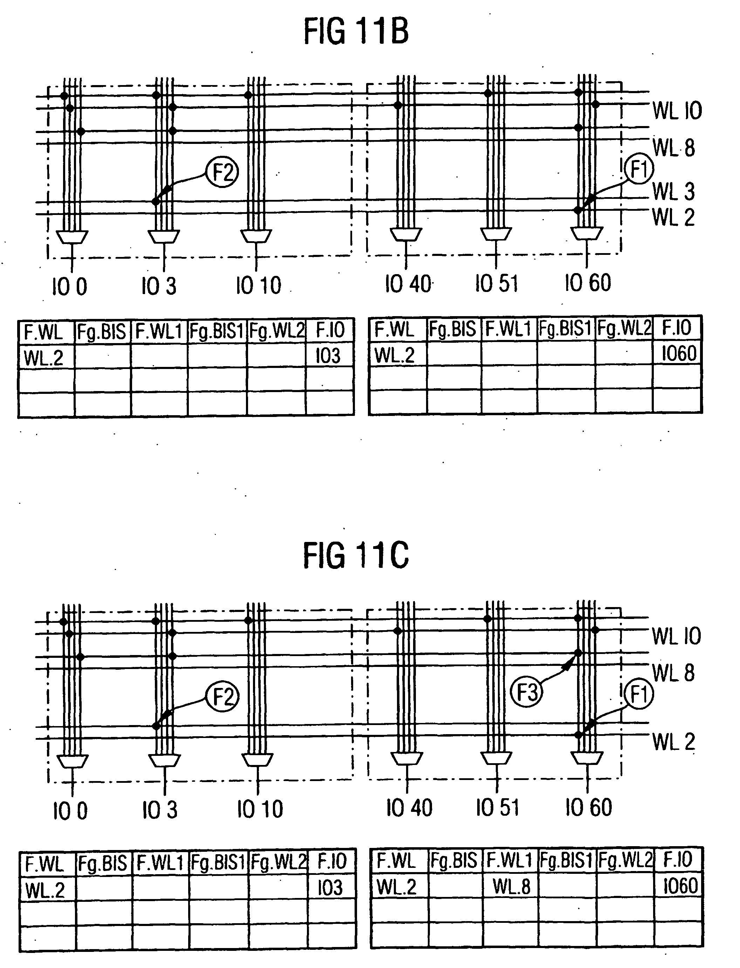

Fig. 11a to 11f show an example of filling the diagnose array 5b shown in Fig. 10.

As can be seen from Fig. 11a, when the built-in self-test unit 4 detects an error F1 of a faulty memory cell connected to wordline WL2 and input/output unit 60 in the right memory half 2b, the X-address of the detected wordline is stored in the first column, and the number of the faulty input/output unit 60 is stored in the last column of line 0 in the right table.

As shown in Fig. 11b, next a further defect memory cell F2 is detected which is connected to the input/output unit 3 and to the wordline 3. Each wordline comprises a couple of wordlines for supplying a differential signal. As the fault is on wordline WL3 and always one couple of wordlines is repaired, WL3 is considered to be equal to wordline WL2 for the storage. The number of the faulty wordline WL2 and the number of the faulty input/output unit IO3 are stored in the left table.

Next, as can be seen from Fig. 11c, a further error F3 is found. The faulty memory cell is connected to wordline 8 and input/output unit 60. The number of the second faulty wordline and the input/output unit 60 are stored in the column F.WL1 of the right table.

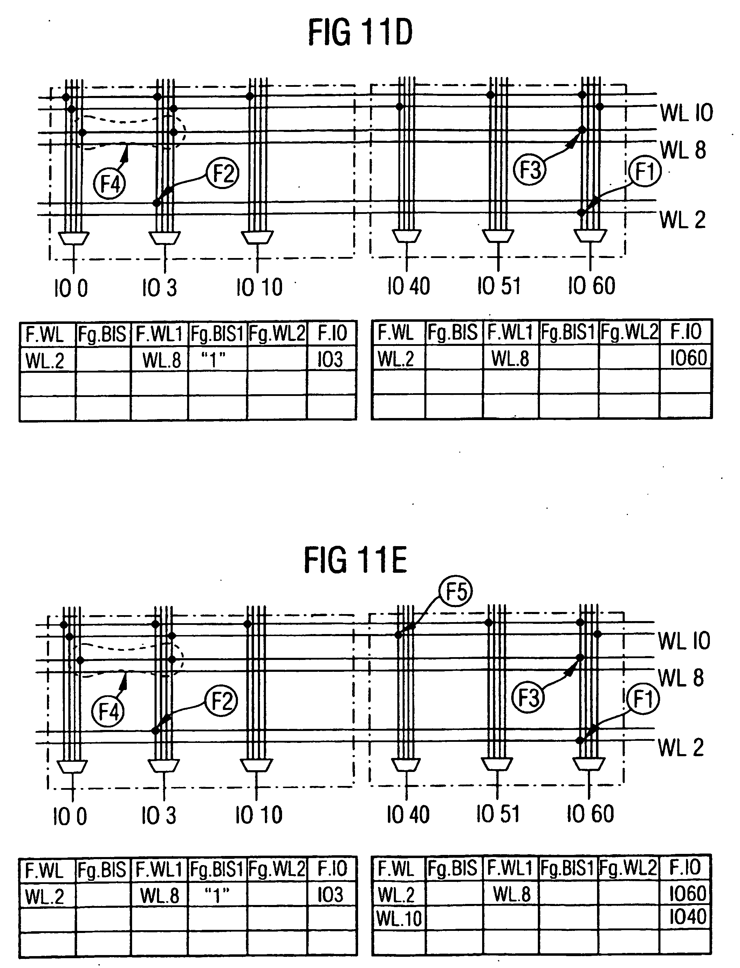

Fig. 11d shows the situation after a further error F4 is detected. As can be seen from Fig. 11d, two defect memory cells connected to wordline 8 are detected. The left table is updated by storing the number of the detected wordline WL8 indicating the second faulty cell in this wordline with the same input/output unit IO3, and a flag Fg.BIS1 is set indicating that there is a new error on the same wordline WL8, but with a different input/output unit (in this case input/output unit I00).

A further error is detected, as can be seen from Fig. 11e. The next error F5 results from a faulty memory cell connected to wordline 10 and input/output unit 40. Since a new input/output unit 40 is concerned, a new line in the right table is activated and the wordline number of the detected faulty address WL10 is written into this line.

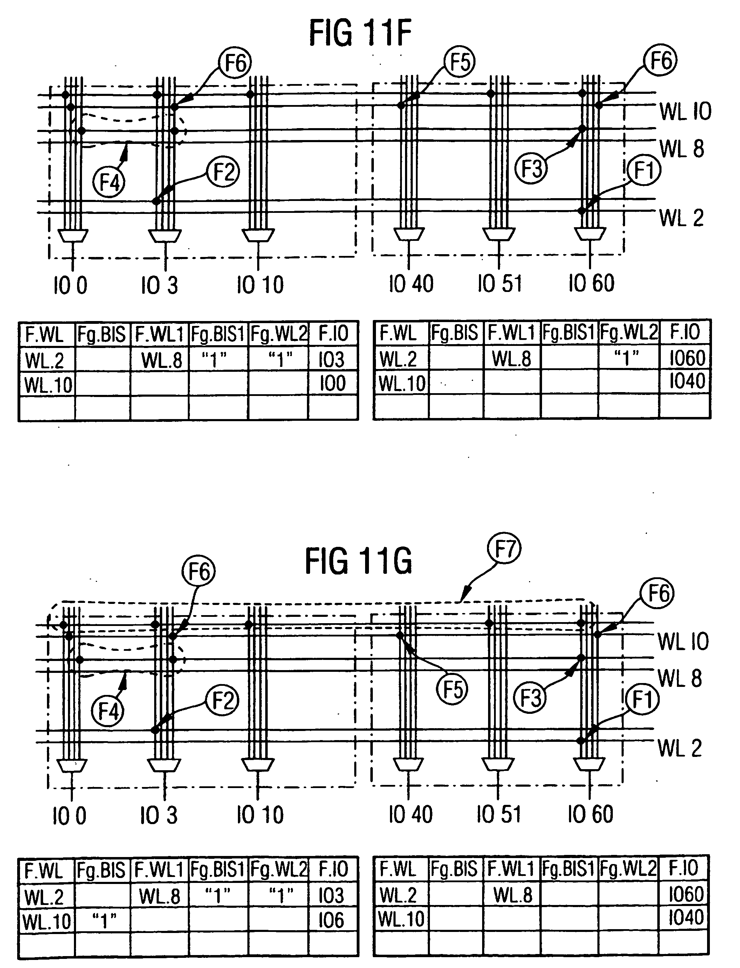

Fig. 11f shows the situation after two additional errors F6 are found. The flag Fg.WL2 in the right table indicates that a third faulty memory cell has been found in wordline 10 connected to the same input/output unit IO60. In the left table, flag Fg.WL2 indicates that a third faulty memory cell has been found connected to wordline WL10 and the same input/output unit IO3.

Fig. 11g shows the situation after finding an error F7 consisting of five faulty memory cells connected to wordline W110. Fg.BIS indicates that there is a new error on the same wordline, but with a different input/output unit.

In the given example in Fig. 11a-11g is a 4k x 64 SRAM 2 having two redundant input/output units and two redundant wordlines. A different kind of redundancy can be used in a memory 2. Possible redundancies are, for example, two redundant wordlines and two redundant input/output units, one redundant wordline and two redundant input/output units, two redundant input/output units, two redundant wordlines or merely one redundant wordline. With the method for storing the detected error according to the present invention, it is for example possible to repair three independent errors, if there are provided two redundant wordlines and one redundant input/output unit. An independent error is an error when the faulty addresses and the input/output units are different. The first independent error can be repaired by replacing the wordline by a redundant wordline. The second error can also be repaired by replacing a wordline with the second redundant wordline, and a third error is repaired by using a redundant input/output unit. If a further error occurs in this situation, either this new error is on the same wordline or input/output unit than a previous error, and it is possible to repair this additional error. If the new error is in a new wordline or the faulty memory cell is connected to another input/output unit than previous errors, this additional error cannot be repaired, and the main memory 2 remains defect.

In the method according to the present invention, each error is memorized by storing its wordline and its input/output unit in a line of the diagnose array 5b. The number of lines required in that array is equal to the number of independent errors which should be repaired with redundancy. If it is decided to repair three independent errors, an array with three lines has to be provided. If more independent errors have to be considered, the number of lines has to be increased accordingly.

Listing-A shows an algorithm for storing detected errors of a main memory 2 in the separate diagnose array 5b as shown in Fig. 10. In the given example, two redundant wordlines and two redundant input/output units are provided.

```
FOR each error detected
      IF WL and IO are already stored in a line of the
diagnose array
            No action required
      ELSE IF IO is already stored in a line of the diagnose
array
```

        Update the WL info (fill F.WL1 or Fg.WL2 if F.WL1 already filled) of the concerned line
        ELSE IF WL is already stored in a line of the diagnose array
Update the WL info (fill Fg.BIS or Fg.BIS1) of the concerned line

```
      ELSE IF a line is available
            Write a new line (fill F.WL and F.IO)
      ELSE
            Memory cannot be repaired
      END IF
   END FOR
```

Listing-B shows an algorithm to analyze detected errors stored in the diagnose array 5b.

```
FOR each line
      IF Fg.BIS = '1'THEN
            The F.WL must be repaired with a redundant WL
      END IF
      IF Fg.BIS1 = '1'THEN
            The F.WL1 must be repaired with a redundant WL
      END IF
      If Fg.WL2 = '1'THEN
            The F.IO must be repaired with a redundant IO
      ELSE
            IF Fg.BIS = '0' and/or Fg.BIS1 = '0' THEN
                  We can repair either the F.IO with a redundant
                  IO either the F.WL with the first redundant WL
                  and the F.WL1(if filled) with he second
                  redundant WL
            END IF
END FOR
```

If, for example, the diagnose table 5b has the data content as shown in Fig. 11g in the left array, the first line flag Fg.BIS1 which is set indicates that wordline WL8 has to be repaired. Flag Fg.WL2 which is also set indicates that the input/output unit IO3 has to be repaired. In the second row, flag Fg.BIS indicates that wordline WL10 has to be repaired.

Analyzing the right half of the array shows in the first line that flag Fg.WL2 is set so that the input/output unit IO60 has to be repaired. In the second line, flag Fg.BIS is set indicating that the wordline WL10 has to be repaired.

The analyzing step indicates that wordlines WL8, input/output unit 3, wordline 10, input/output unit 60 and wordline 10 have to be repaired. Since wordline 10 is a double match ....., the diagnose unit 5 can control the repair unit 6 in such a way that the repair unit 6 programs fuses 7 to repair wordline 8, input/output unit 3, wordline 10 and input/output unit 60. The repair is performed by substituting found wordlines and input/output units by redundant wordlines and redundant input/output units provided in the main memory 2 of the memory chip 1.

The necessary storage capacity of the diagnose array 5b shown in Fig. 10 is very low so that the necessary chip area for implementing this diagnose array is very small. A further advantage of the memory chip according to the present invention is that the area necessary for the error storage is independent of the size of the memory to be repaired. The diagnose of the best repair solution can be performed very fast, because during the BIST-algorithm performed by the built-in self-test unit 4 of the memory chip 1, a pretreatment has already occurred, i.e. the faulty wordlines and input/output units are already detected. In the given example, the diagnose unit 5 needs only five clock cycles to find the repair solution. In a conventional memory chip, the diagnose unit needs a number of clock cycles that depends on the respective memory size of the main memory. The method according to the present invention is independent of the architecture of the memory, independent of the used BIST-algorithm and independent of the kind of memory, i.e. the method can be used for all kind of memories such as SRAM, DRAM and CAM.

With the present invention, it is possible to store all errors detected in a memory in an array with a minimum storage size depending only on the kind of redundancy, i.e. the number of redundant wordlines and/or redundant bitlines provided in the memory 2.

**Claims**

1.   Method for storing detected errors of a main memory (2) in a separate diagnose array (5b) within a diagnose unit (5) having a minimum storage size,

wherein the faulty main memory (2) to be repaired comprises a plurality of memory cells which are addressable by means of wordlines (WL) connected to wordline address decoders (8) and by means of bitlines (BL) connected to input/output units (9),

said method comprising the following steps:

(a) providing a faulty diagnose array (5b) having several lines, wherein the number of the lines is equal to the number of independent errors of the faulty main memory (2) that can be repaired,

wherein in each line of said diagnose array (5b) are storable:

(a1) at least one wordline number (FWL, FWL1) of a wordline connected to a detected faulty memory cell,

(a2) an input/output unit number (F.IO) of an input/output unit connected to the detected faulty memory cell,

(a3) at least one first flag (Fg.BIS, Fg.BIS1) which indicates whether a new error on the same wordline, but with a different input/output unit has occurred, and

(a4) a second flag (Fg.WL2) which indicates whether a further faulty wordline with the same input/output unit has occurred;

(b) comparing the wordline number and the input/output unit number of the detected faulty memory cell with the data content of the faulty diagnose array (5b), wherein

(b1) IF the wordline number and the input/output unit number of the detected faulty memory cell are already stored in a line of said array, no update of said fault diagnose array is performed,

(b2) ELSE, if the input/output unit number of the detected faulty memory cell is already stored in a line of said array, the wordline number is stored in said line,

(b3) ELSE, if the wordline number of the detected faulty memory cell is already stored in a line of said array, a first flag is set in said line,

(b4) ELSE, if a further line is available in said fault diagnose array (5b), the wordline number and the input/output unit number of the detected faulty memory cell is written into said further line,

(b5) ELSE, it is indicated that the main memory (2) cannot be repaired.

2. Method according to claim 1, wherein the detected errors stored in said diagnose array (5b) are analyzed to select wordlines and input/output units to be replaced by redundant wordlines and redundant input/output units of said main memory (2).

3. Method according to claim 2, wherein the analyzing of the errors is performed by a control unit (5a) within the diagnose unit (5) connected to said diagnose array (5b).

4. Method according to claim 3, wherein analyzing the errors comprises the following steps for each line of the diagnose array (5b), wherein

if a first flag is set within the line, then it is decided that the corresponding wordline is to be replaced by a redundant wordline,

if the second flag is set within the line, then it is decided that the faulty input/output unit is to be replaced by a redundant input/output unit,

if the second flag is not set and a first flag is not set, then it is decided that either the faulty input/output unit is replaced by a redundant input/output unit or the faulty wordline with a redundant wordline.

5. Method according to one of the preceding claims, wherein the diagnose unit (5) controls a repair unit (6) to program fuses for replacing wordlines by redundant wordlines and input/output units by redundant input/output units according to the analyzing result.

6. Memory chip comprising:

(a) a main memory (2) with a plurality of memory cells which are addressable by means of wordlines (WL) connected to wordline address decoders (8) and by means of bitlines (BL) connected to input/output units (9), wherein the main memory (2) has redundant wordlines WL connected to redundant wordline address decoders (11) and redundant bitlines (BL) connected to redundant input/output units (12);

(b) a built-in self-test unit (4) for detecting faulty memory cells in said main memory (2);

(c) a diagnose unit (5) having

(c1) a diagnose array (5b) for storing logically detected errors of the main memory (2),
wherein the diagnose array (5b) has several lines the number of which is equal to the number of independent errors in the faulty main memory (2) that can be repaired, wherein in each line of the diagnose array (5b) are storable:

at least one wordline number (FWL, FWL1) of a wordline connected to a detected faulty memory cell,
an input/output unit number (F.IO) of an input/output unit connected to the detected faulty memory cell,
at least one first flag (Fg.BIS, Fg.BIS1) which indicates whether a new error on the same wordline, but with a different input/output unit has occurred, and
a second flag (Fg.WL2) which indicates whether a further faulty wordline with the same input/output unit has occurred;

(c2) a control unit (5a) for comparing
the wordline number and the input/output unit number of the detected faulty memory cell with the data content of the faulty diagnose array (5b), wherein
IF the wordline number and the input/output unit number of the detected faulty memory cell are already stored in a line of said array, no update of said fault diagnose array is performed,
ELSE, if the input/output unit number of the detected faulty memory cell is already stored in a line of said array, the wordline number is stored in said line,
ELSE, if the wordline number of the detected faulty memory cell is already stored in a line of said array, a first flag is set in said line,
ELSE, if a further line is available in said fault diagnose array (5b), the wordline number and the input/output unit number of the detected faulty memory cell is written into said further line,
ELSE, it is indicated that the main memory (2) cannot be repaired.

7. Memory chip according to claim 6,
wherein the diagnose unit (5) controls a repair unit (6) to program fuses (7) for replacing wordlines by redundant wordlines and input/output units by redundant input/output units.


**Patentansprüche**

1. Verfahren zum Speichern von erfassten Fehlern eines Hauptspeichers (2) in einem separaten Diagnosearray (5b) innerhalb einer Diagnoseeinheit (5), die eine minimale Speichergröße aufweist,
wobei der zu reparierende fehlerhafte Hauptspeicher (2) eine Vielzahl von Speicherzellen aufweist, welche mittels Wortleitungen (WL), die mit Wortleitungsadressdekodern (8) verbunden sind, und mittels Bitleitungen (BL) adressierbar sind, die mit Ein-/Ausgabeeinheiten (9) verbunden sind,
wobei
das Verfahren die folgenden Verfahrensschritte aufweist:

(a) Vorsehen eines Fehlerdiagnosearrays (5b) mit mehreren Zeilen, wobei die Anzahl der Zeilen gleich der Anzahl von unabhängigen Fehlern des reparierbaren fehlerhaften Hauptspeichers (2) ist,
wobei in jeder Zeile des Diagnosearrays (5b) Folgendes speicherbar ist:

(a1) mindestens eine Wortleitungszahl (FWL, FWL1) einer Wortleitung, die mit einer erfassten fehlerhaften Speicherzelle verbunden ist,
(a2) eine Ein-/Ausgabeeinheitszahl (F.IO) einer Ein-/Ausgabeeinheit, die mit der erfassten fehlerhaften Speicherzelle verbunden ist,
(a3) mindestens ein erstes Flag (Fg.BIS, Fg.BIS1), welches anzeigt, ob ein neuer Fehler auf derselben Wortleitung aber mit einer unterschiedlichen Ein-/Ausgabeeinheit aufgetreten ist, und
(a4) ein zweites Flag (Fg.WL2), welches anzeigt, ob eine weitere fehlerhafte Wortleitung mit derselben Ein-/Ausgabeeinheit aufgetreten ist;

(b) Vergleichen der Wortleitungszahl und der Ein-/Ausgabeeinheitszahl der erfassten fehlerhaften Speicherzelle mit dem Dateninhalt des Fehlerdiagnosearrays (5b), wobei

(b1) WENN die Wortleitungszahl und die Ein-/Ausgabeeinheitszahl der erfassten fehlerhaften Speicherzelle bereits in einer Zeile des Arrays gespeichert sind, kein Aktualisieren des Fehlerdiagnosearrays durchgeführt wird,
(b2) SONST, wenn die Ein-/Ausgabeeinheitszahl der erfassten fehlerhaften Speicherzelle bereits in einer Zeile des Fehlerdiagnosearrays gespeichert worden ist, die Wortleitungszahl in der Zeile gespeichert wird,
(b3) SONST, wenn die Wortleitungszahl der erfassten fehlerhaften Speicherzelle bereits in einer Zeile des Arrays gespeichert ist, in der Zeile ein erstes Flag gesetzt wird,
(b4) SONST, wenn eine weitere Zeile in dem Fehlerdiagnosearray (5b) verfügbar ist, die Wortleitungszahl und die Ein-/Ausgabeeinheitszahl der erfassten fehlerhaften Speicherzelle in die weitere Zeile eingeschrieben werden,
(b5) SONST angezeigt wird, dass der Hauptspeicher (2) nicht repariert werden kann.

2. Verfahren nach Anspruch 1,
wobei
die in dem Diagnosearray (5b) gespeicherten erfassten Fehler analysiert werden, um von redundanten Wortleitungen und redundanten Ein-/Ausgabeeinheiten des Hauptspeichers (2) zu ersetzende Wortleitungen und Ein-/Ausgabeeinheiten auszuwählen.

3. Verfahren nach Anspruch 2,
wobei
das Analysieren der Fehler in einer bevorzugten Ausführungsform von einer Steuereinheit (5a) innerhalb der Diagnoseeinheit (5) ausgeführt wird, die mit dem Diagnosearray (5b) verbunden ist.

4. Verfahren nach Anspruch 3,
wobei
ein Analysieren der Fehler die folgenden Verfahrensschritte für jede Zeile des Diagnosearrays (5b) aufweist, wobei wenn das erste Flag innerhalb der Zeile gesetzt ist, entschieden wird, dass die korrespondierende Wortleitung durch eine redundante Wortleitung zu ersetzen ist;
wenn das zweite Flag innerhalb der Zeile gesetzt ist, entschieden wird, dass die fehlerhafte Ein-/Ausgabeeinheit durch eine redundante Ein-/Ausgabeeinheit zu ersetzen ist; wenn das zweite Flag nicht gesetzt ist und ein erstes Flag nicht gesetzt ist, entschieden wird, dass entweder die fehlerhafte Ein-/Ausgabeeinheit durch eine redundante Ein-/Ausgabeeinheit ersetzt wird oder die fehlerhafte Wortleitung durch eine redundante Wortleitung ersetzt wird.

5. Verfahren nach einem der vorhergehenden Ansprüche,
wobei
die Diagnoseeinheit (5) eine Reparatureinheit (6) zum Programmieren von Fuses zum Ersetzen von Wortleitungen durch redundante Wortleitungen und Ein-/Ausgabeeinheiten durch redundante Ein-/Ausgabeeinheiten gemäß dem Analyseergebnis steuert.

6. Speicherchip, welcher Folgendes aufweist:

(a) einen Hauptspeicher (2) mit einer Vielzahl von Speicherzellen, welche mittels Wortleitungen (WL), die mit Wortleitungsadressdekodern (8) verbunden sind, und mittels Bitleitungen (BL) adressierbar ist, die mit Ein-/Ausgabeeinheiten (9) verbunden sind,
wobei der Hauptspeicher (2) redundante Wortleitungen (WL), die mit redundanten Wortleitungsadressdekodern (11) verbunden sind, und redundante Bitleitungen (BL) aufweist, die mit redundanten Ein-/Ausgabeeinheiten (12) verbunden sind;

(b) eine eingebaute Selbsttesteinheit (4) zur Erfassung von fehlerhaften Speicherzellen in dem Hauptspeicher (2);

(c) eine Diagnoseeinheit (5) mit:

(c1) einem Diagnosearray (5b) zur Speicherung logisch erfasster Fehler des Hauptspeichers (2),
wobei das Diagnosearray (5b) mehrere Zeilen aufweist, deren Anzahl gleich der Anzahl von unabhängigen Fehlern in dem fehlerhaften Hauptspeicher (2) ist, der reparierbar ist,
wobei in jeder Zeile des Diagnosearrays (5b) Folgendes speicherbar ist:

mindestens eine Wortleitungszahl (FWL, FWL1) einer Wortleitung, welche mit einer fehlerhaften Speicherzelle verbunden ist;

eine Ein-/Ausgabeeinheitszahl (F.IO) einer Ein-/Ausgabeeinheit, welche mit der fehlerhaften Speicherzelle verbunden ist;

mindestens ein erstes Flag (Fg.BIS, Fg.BIS1), welches anzeigt, ob ein neuer Fehler derselben Wortleitung aber mit einer unterschiedlichen Ein-/Ausgabeeinheit aufgetreten ist; und

ein zweites Flag (Fg.WL2), welches anzeigt, ob eine weitere fehlerhafte Wortleitung mit derselben Ein-/Ausgabeeinheit aufgetreten ist;

(c2) einer Steuereinheit (5a) zum Vergleich der Wortleitungszahl und der Ein-/Ausgabeeinheitszahl der erfassten fehlerhaften Speicherzelle mit dem Dateninhalt des Fehlerdiagnosearrays (5b), wobei

WENN die Wortleitungszahl und die Ein-/Ausgabeeinheitszahl der erfassten fehlerhaften Speicherzelle bereits in einer Zeile des Fehlerdiagnosearrays gespeichert sind, keine Aktualisierung des Fehlerdiagnosearrays ausgeführt wird; SONST, wenn die Ein-/Ausgabeeinheitszahl der erfassten fehlerhaften Speicherzelle bereits in einer Zeile des Fehlerdiagnosearrays gespeichert ist, die Wortleitungszahl in der Zeile gespeichert wird;

SONST, wenn die Wortleitungszahl der erfassten fehlerhaften Speicherzelle bereits in einer Zeile des Fehlerdiagnosearrays gespeichert ist, ein erstes Flag in der Zeile gesetzt wird;

SONST, wenn eine weitere Zeile in dem Fehlerdiagnosearray (5b) verfügbar ist, die Wortleitungszahl und die Ein-/Ausgabeeinheitszahl der erfassten fehlerhaften Speicherzelle in die weitere Zeile eingeschrieben werden;

SONST entschieden wird, dass der Hauptspeicher (2) nicht reparierbar ist.

7. Speicherchip nach Anspruch 6,
wobei
die Diagnoseeinheit (5) eine Reparatureinheit (6) zur Programmierung von Fuses (7) zum Ersatz von Wortleitungen durch redundante Wortleitungen und Ein-/Ausgabeeinheiten durch redundante Ein-/Ausgabeeinheiten steuert.

**Revendications**

1. Procédé pour stocker des erreurs détectées d'une mémoire principale (2) dans une matrice de diagnostic distincte (5b) à l'intérieur d'une unité de diagnostic (5) ayant une taille de stockage minimale,
dans lequel la mémoire principale défectueuse (2) à réparer comprend une pluralité de cellules de mémoire qui sont adressables au moyen de lignes de mots (WL) reliées à des décodeurs d'adresse de ligne de mots (8) et au moyen de lignes de bits (BL) reliées à des unités d'entrée / sortie (9),
ledit procédé comprenant les étapes consistant à :

(a) prévoir une matrice de diagnostic de défauts (5b) ayant plusieurs lignes, dans laquelle le nombre des lignes est égal au nombre des erreurs indépendantes de la mémoire principale défectueuse (2) qui peuvent être réparées,
dans lequel, dans chaque ligne de ladite matrice de diagnostic (5b), on peut stocker :

(a1) au moins un numéro de ligne de mots (FWL, FWL1) d'une ligne de mots reliée à une cellule de mémoire défectueuse détectée,
(a2) un numéro d'unité d'entrée / sortie (F.IO) d'une unité d'entrée / sortie reliée à la cellule de mémoire défectueuse détectée,
(a3) au moins un premier indicateur (Fg.BIS, Fg.BIS1) qui indique si une nouvelle erreur sur la même ligne de mots, mais avec une unité d'entrée / sortie différente, s'est produite, et
(a4) un second indicateur (Fg.WL2) qui indique si une nouvelle ligne de mots défectueuse avec la même unité d'entrée / sortie s'est produite ;
(b) comparer le numéro de ligne de mots et le numéro d'unité d'entrée / sortie de la cellule de mémoire défectueuse détectée au contenu de données de la matrice de diagnostic des défauts (5b), dans laquelle
(b1) SI le numéro de ligne de mots et le numéro d'unité d'entrée / sortie de la cellule de mémoire défectueuse détectée sont déjà stockés dans une ligne de ladite matrice, aucune mise à jour de ladite matrice de diagnostic de défauts n'est effectuée,
(b2) SINON, si le numéro d'unité d'entrée / sortie de la cellule de mémoire défectueuse détectée est déjà stocké dans une ligne de ladite matrice, le numéro de ligne de mots est stocké dans ladite ligne,

(b3) SINON, si le numéro de ligne de mots de la cellule de mémoire défectueuse détectée est déjà stocké dans une ligne de ladite matrice, un premier indicateur est mis à un dans ladite ligne,

(b4) SINON, si une ligne supplémentaire est disponible dans ladite matrice de diagnostic de défauts (5b), le numéro de ligne de mots et le numéro d'unité d'entrée / sortie de la cellule de mémoire défectueuse détectée sont écrits dans ladite ligne supplémentaire,

(b5) SINON, on indique que la mémoire principale (2) ne peut pas être réparée.

2. Procédé selon la revendication 1, dans lequel les erreurs détectées stockées dans ladite matrice de diagnostic (5b) sont analysées pour sélectionner des lignes de mots et des unités d'entrée / sortie à remplacer par des lignes de mots redondantes et des unités d'entrée / sortie redondantes de ladite mémoire principale (2).

3. Procédé selon la revendication 2, dans lequel l'analyse des erreurs est effectuée par une unité de commande (5a) à l'intérieur de l'unité de diagnostic (5), reliée à ladite matrice de diagnostic (5b).

4. Procédé selon la revendication 3, dans lequel l'analyse des erreurs comprend les étapes suivantes pour chaque ligne de la matrice de diagnostic (5b), dans lequel :

si un premier indicateur est mis à un à l'intérieur de la ligne, alors on détermine que la ligne de mots correspondante doit être remplacée par une ligne de mots redondante,

si le second indicateur est mis à un à l'intérieur de la ligne, alors on détermine que l'unité d'entrée / sortie défectueuse doit être remplacée par une unité d'entrée / sortie redondante,

si le second indicateur n'est pas mis à un et que le premier indicateur n'est pas mis à un, alors on détermine que l'unité d'entrée / sortie défectueuse est remplacée par une unité d'entrée / sortie redondante ou que la ligne de mots défectueuse est remplacée par une ligne de mots redondante.

5. Procédé selon l'une des revendications précédentes, dans lequel l'unité de diagnostic (5) commande une unité de réparation (6) pour programmer des fusibles pour remplacer des lignes de mots par des lignes de mots redondantes et des unités d'entrée / sortie par des unités d'entrée / sortie redondantes selon le résultat de l'analyse.

6. Puce de mémoire comprenant :

(a) une mémoire principale (2) ayant une pluralité des cellules de mémoire qui sont adressables au moyen de lignes de mots (WL) reliées à des décodeurs d'adresse de ligne de mots (8) et au moyen de lignes de bits (BL) reliées à des unités d'entrée / sortie (9),

dans laquelle la mémoire principale (2) possède des lignes de mots redondantes WL reliées à des décodeurs d'adresse de ligne de mots redondants (11) et des lignes de bits redondantes (BL) reliées à des unités d'entrée / sortie redondantes (12) ;

(b) une unité d'auto-test intégrée (4) pour détecter des cellules de mémoire défectueuses dans ladite mémoire principale (2) ;

(c) une unité de diagnostic (5) ayant

(c1) une matrice de diagnostic (5b) pour stocker des erreurs de la mémoire principale (2) détectées d'un point de vue logique,

dans laquelle la matrice de diagnostic (5b) possède plusieurs lignes dont le nombre est égal au nombre d'erreurs indépendantes dans la mémoire principale défectueuse (2) qui peuvent être réparées,

dans laquelle dans chaque ligne de la matrice de diagnostic (5b), on peut stocker :

au moins un numéro de ligne de mots (FWL, FWL1) d'une ligne de mots reliée à une cellule de mémoire défectueuse détectée, un numéro d'unité d'entrée / sortie (F.IO) d'une unité d'entrée / sortie reliée à la cellule de mémoire défectueuse détectée,

au moins un premier indicateur (Fg.BIS, Fg.BIS1) qui indique si une nouvelle erreur sur la même ligne de mot, mais avec une unité d'entrée / sortie différente, s'est produite, et

un second indicateur (Fg.WL2) qui indique si une ligne de mots défectueuse supplémentaire avec la même unité d'entrée / sortie s'est produite ;

(c2) une unité de commande (5a) pour comparer

le numéro de ligne de mots et le numéro d'unité d'entrée / sortie de la cellule de mémoire défectueuse détectée au contenu de données de la matrice de diagnostic de défauts (5b), dans laquelle

SI le numéro de ligne de mots et le numéro d'unité d'entrée / sortie de la cellule de mémoire défectueuse détectée sont déjà stockés dans une ligne de ladite matrice, aucune mise à jour de ladite matrice de diagnostic de défauts n'est effectuée,

SINON, si le numéro d'unité d'entrée / sortie de la cellule de mémoire défectueuse détectée est déjà stocké dans une ligne de ladite matrice, le numéro de ligne de mots est stocké dans ladite ligne,

SINON, si le numéro de ligne de mots de la cellule de mémoire défectueuse détectée est déjà stocké dans une ligne de ladite matrice, un premier indicateur est mis à un dans ladite ligne,

SINON, si une ligne supplémentaire est disponible dans ladite matrice de diagnostic de défauts (5b), le numéro de ligne de mots et le numéro d'unité d'entrée / sortie de la cellule de mémoire défectueuse détectée sont écrits dans ladite ligne supplémentaire,

SINON, on indique que la mémoire principale (2) ne peut pas être réparée.

7. Puce de mémoire selon la revendication 6,
dans laquelle l'unité de diagnostic (5) commande une unité de réparation (6) pour programmer des fusibles (7) pour remplacer des lignes de mots par des lignes de mots redondantes et des unités d'entrée / sortie par des unités d'entrée / sortie redondantes.

# FIG 1
## PRIOR ART

Address - Bus

Control - Bus

Data in

Fuse-boxes

Redundancy Logic

RAM main memory

MUX

Memory-Chip

Data out

# FIG 2
## PRIOR ART

# FIG 3
## PRIOR ART

MUX-A, MUX-B, MUX-C

$BL_1$, $\overline{BL_1}$, $BL_N$, $\overline{BL_N}$

I/O A, I/O B, I/O C

y-address

3

16

FIG 4
PRIOR ART

XDEC

XDEC

8 8 8

WLSA WLSE WLSC

PRE-Decoder

x-address

EP 1 408 512 B1

**FIG 5**

Memory with
redundancy

Fuses

BIST-
unit

Diagnose-
unit

Repair-
unit

**FIG 6**

Control
unit

5a

Diagnose
array

5b

Diagnose unit

5

FIG 7

# FIG 8

XDEC 8-1

XDEC 8-N

XDEC RED B 11-1

XDEC RED A 11-2

8/ 8/ 8/

WLSA WLSB WLSC WLS0 red WLS1 red

PRE-Decoder 13b

13

WLRED B WLRED A

Comparator 13a

X addresses

14

Fuse info 15

Fuse info

7

FIG 9

EP 1 408 512 B1

# FIG 10

Example with a SRAM 4k x 16 and 2 redundant IO and 2 redundant WL

- Storage : for half memory

5b

|  | F. WL | Fg. BIS | F.WL1 | Fg. BIS1 | Fg. WL2 | F.IO |
|---|---|---|---|---|---|---|
| line 0 | Max=255 |  | Max=255 |  |  | Max=31 |
| line 1 | " |  | " |  |  | " |
| line 2 | " |  | " |  |  | " |

F.WL     number of the faulty Word-Line

Fg.BIS    Flag if we name a new error on the same WL than F.WL but with a different IO

F.WL1    number of a second faulty Word-Line with the same IO

Fg.BIS1   Flag if we name a new error on the same WL than F.WL1 but with a different IO

Fg.WL2   Flag if we have a third faulty-Line with the same IO

F.IO      Number of the faulty IO

# FIG 11A

| F.WL | Fg.BIS | F.WL1 | Fg.BIS1 | Fg.WL2 | F.IO |
|---|---|---|---|---|---|
|  |  |  |  |  |  |
|  |  |  |  |  |  |
|  |  |  |  |  |  |

| F.WL | Fg.BIS | F.WL1 | Fg.BIS1 | Fg.WL2 | F.IO |
|---|---|---|---|---|---|
| WL.2 |  |  |  |  | IO60 |
|  |  |  |  |  |  |
|  |  |  |  |  |  |

# FIG 11B

| F.WL | Fg.BIS | F.WL1 | Fg.BIS1 | Fg.WL2 | F.IO |
|------|--------|-------|---------|--------|------|
| WL.2 |        |       |         |        | IO3  |
|      |        |       |         |        |      |
|      |        |       |         |        |      |

| F.WL | Fg.BIS | F.WL1 | Fg.BIS1 | Fg.WL2 | F.IO  |
|------|--------|-------|---------|--------|-------|
| WL.2 |        |       |         |        | IO60  |
|      |        |       |         |        |       |
|      |        |       |         |        |       |

# FIG 11C

| F.WL | Fg.BIS | F.WL1 | Fg.BIS1 | Fg.WL2 | F.IO |
|------|--------|-------|---------|--------|------|
| WL.2 |        |       |         |        | IO3  |
|      |        |       |         |        |      |
|      |        |       |         |        |      |

| F.WL | Fg.BIS | F.WL1 | Fg.BIS1 | Fg.WL2 | F.IO  |
|------|--------|-------|---------|--------|-------|
| WL.2 |        | WL.8  |         |        | IO60  |
|      |        |       |         |        |       |
|      |        |       |         |        |       |

# FIG 11D

| F.WL | Fg.BIS | F.WL1 | Fg.BIS1 | Fg.WL2 | F.IO |
|------|--------|-------|---------|--------|------|
| WL.2 |        | WL.8  | "1"     |        | IO3  |
|      |        |       |         |        |      |
|      |        |       |         |        |      |

| F.WL | Fg.BIS | F.WL1 | Fg.BIS1 | Fg.WL2 | F.IO |
|------|--------|-------|---------|--------|------|
| WL.2 |        | WL.8  |         |        | IO60 |
|      |        |       |         |        |      |
|      |        |       |         |        |      |

# FIG 11E

| F.WL | Fg.BIS | F.WL1 | Fg.BIS1 | Fg.WL2 | F.IO |
|------|--------|-------|---------|--------|------|
| WL.2 |        | WL.8  | "1"     |        | IO3  |
|      |        |       |         |        |      |
|      |        |       |         |        |      |

| F.WL  | Fg.BIS | F.WL1 | Fg.BIS1 | Fg.WL2 | F.IO |
|-------|--------|-------|---------|--------|------|
| WL.2  |        | WL.8  |         |        | IO60 |
| WL.10 |        |       |         |        | IO40 |
|       |        |       |         |        |      |

## FIG 11F

| F.WL | Fg.BIS | F.WL1 | Fg.BIS1 | Fg.WL2 | F.IO |
|------|--------|-------|---------|--------|------|
| WL.2 | | WL.8 | "1" | "1" | I03 |
| WL.10 | | | | | I00 |
| | | | | | |

| F.WL | Fg.BIS | F.WL1 | Fg.BIS1 | Fg.WL2 | F.IO |
|------|--------|-------|---------|--------|------|
| WL.2 | | WL.8 | | "1" | I060 |
| WL.10 | | | | | I040 |
| | | | | | |

## FIG 11G

| F.WL | Fg.BIS | F.WL1 | Fg.BIS1 | Fg.WL2 | F.IO |
|------|--------|-------|---------|--------|------|
| WL.2 | | WL.8 | "1" | "1" | I03 |
| WL.10 | "1" | | | | I06 |
| | | | | | |

| F.WL | Fg.BIS | F.WL1 | Fg.BIS1 | Fg.WL2 | F.IO |
|------|--------|-------|---------|--------|------|
| WL.2 | | WL.8 | | | I060 |
| WL.10 | | | | | I040 |
| | | | | | |